# EUROPÄISCHE PATENTANMELDUNG

(11) **EP 1 684 436 A1**
(43) Veröffentlichungstag der Anmeldung: **26.07.2006**
(21) Anmeldenummer: 06000151.8
(22) Anmeldetag: 04.01.2006
(51) Int. Cl.: H03M 9/00, H01L 21/8242

(54) **Synchroner Parallel-Serienwandler**

(30) Priorität: 14.01.2005 DE 102005001894
(71) Anmelder: Infineon Technologies AG, 81669 München (DE)
(72) Erfinder: Wallner, Paul, Dr., 83209 Prien (DE); Gregorius, Peter, 81476 München (DE); Schledz, Ralf, 85406 Zolling (DE)
(74) Vertreter: Müller - Hoffmann & Partner

(57) **Zusammenfassung**

Die Erfindung betrifft einen synchronen Parallel-Serienwandler zur Wandlung eines parallelen n Bit Eingangssignals in einen seriellen Ein-Bit-Ausgangssignalstrom (D3(1/1)) synchron zu einem Taktsignal (clk_hr_i), das, bezogen auf eine Taktrate eines Systemtakts (sys_clk) die halbe Taktrate hat, wobei der Parallel-Serienwandler (1) aufweist: ein erstes Schieberegister (SR_od), das synchron zur Rück- oder Vorderflanke des Taktsignals (clk_hr_i) einen ungeradzahligen Teil (D1_od(1/8)) des Eingangssignals mit einem ersten Ladesignal (odload_i) parallel übernimmt und seriell als eine erste Ein-Bit-Signalfolge (D2_od(1/2)) ausgibt; ein zweites Schieberegister (SR_ev), das synchron zur Vorder- oder Rückflanke des Taktsignals (clk_hr_i) einen geradzahligen Teil (D1_ev(1/8)) des Eingangssignals mit einem zweiten Ladesignal (evload_i) parallel übernimmt und seriell als eine zweite Ein-Bit-Signalfolge (D2_ev(1/2)) ausgibt, und eine Verschmelzungseinheit (M), die die erste Ein-Bit-Signalfolge (D2_od(1/2)) von dem ersten Schieberegister (SR_od), die zweite Ein-Bit-Signalfolge (D2_ev(1/2)) von dem zweiten Schieberegister (SR_ev) und das Taktsignal (clk_hr_i) empfängt und die erste Ein-Bit-Signalfolge (D2_od(1/2)) synchron mit der Rück- oder Vorderflanke des Taktsignals (clk_hr_i) und die zweite Ein-Bit-Signalfolge (D2_ev(1/2)) synchron mit der Vorder- oder Rückflanke des Taktsignals (clk_hr_i) zu dem Ausgangssignalstrom (D3(1/1)) verschmilzt und diesen ausgibt.

## Beschreibung

### Synchroner Parallel-Serienwandler

Die Erfindung betrifft einen synchronen Parallel-Serienwandler zur Wandlung eines parallelen n-Bit-Eingangssignals in eine serielle Ein-Bit-Ausgangssignalfolge synchron zu einem Taktsignal, das bezogen auf die Taktrate eines Systemtaktsignals die halbe Taktrate hat.

Bei bisherigen DDR-DRAM-Halbleiterspeichern wurden den einzelnen Halbleiterspeicherbausteinen die Daten-, Adress- und Steuersignale sowie Taktsignale jeweils über getrennte Busleitungssysteme zugeführt. Die Übertragung der Lese- und Schreibdaten erfolgte gewöhnlich bidirektional in einer bestimmten Anzahl von parallelen Datenbits.

Bedingt durch die beträchtlich höheren Übertragungsgeschwindigkeiten (bis zu 7,2 GBit/s pro Pin) werden bei den derzeit in Entwicklung befindlichen DDR-DRAM-Speichern der folgenden Generation (z.B. DDR4 bzw. NMT (New Memory Technology)) Datensignale sowie Adress- und Steuersignale und auch die Taktsignale über differentielle Signalleitungen übertragen. Aus diesem Grunde würde sich bei der herkömmlichen Architektur der Speichersende- und -empfangsschnittstellen die Pinzahl für diese Signale wenigstens verdoppeln. Eine derart erhöhte Pinzahl ist jedoch weder bei den einzelnen Speicherbausteinen (Chips) noch bei den diese tragenden Speichermodulen erwünscht oder möglich.

Zur Reduzierung der Pinzahl und, da die Übertragung der Daten-, Steuer- und Adresssignale bei der folgenden Speichergeneration unidirektional erfolgt, werden neue Sende- und Empfangsschnittstellenschaltungen entwickelt, die die zu übertragenden Daten-, Steuer- und Adresssignale innerhalb eines Rahmens (Signalframe), das heißt jeweils übereinstimmend mit einem Sende- und Empfangsprotokoll unter Einhaltung sehr strikter zeitlicher Bedingungen senden bzw. empfangen. Selbstverständlich werden diese Signale ebenfalls differentiell übertragen, wobei das Taktsignal separat übertragen wird. Derartige protokollorientierte Sende- und Empfangsschnittstellenschaltungen erfordern schnelle Codier- und Decodierlogiken im Sende- und Empfangsabschnitt des Speicherinterfaces, wobei im Empfangsabschnitt Daten- und Taktaufbereitung notwendig sind.

Um die aus den Speicherarrays ausgelesenen und zu sendenden Datenbits in einen mit dem Protokoll übereinstimmenden Datenstrom zu vereinigen, bedarf es im Sendeteil der Speicherschnittstelle einer Parallel-Serienwandlung, die die aus den Speicherarrays zu mehreren Bit parallel ausgelesenen Daten synchron zum Taktsignal in einen seriellen Ein-Bit-Datensignalstrom umwandelt.

Es ist deshalb Aufgabe der Erfindung, einen für eine derartige Parallel-Serienwandlung im Sendeteil einer Speicherschnittstelle der folgenden DDR-DRAM-Generationen angepassten synchronen Parallel-Serienwandler zur Wandlung eines parallelen n-Bit-Eingangssignals in einen seriellen Ausgangssignalstrom synchron zu einem Taktsignal so anzugeben, dass eine sichere und stabile Übernahme des Eingangssignals unter gleichzeitiger Einhaltung einer geringen Latenzzeit desselben in dem Parallel-Serienwandler erreicht ist.

Diese Aufgabe wird anspruchsgemäß gelöst.

Gemäß einem grundlegenden Aspekt ist ein synchroner Parallel-Serienwandler zur Wandlung eines parallelen n-Bit-Eingangssignal in einen seriellen Ein-Bit-Ausgangssignalstrom synchron zu einem Taktsignal, das bezogen auf die Taktrate eines Systemtaktsignals die halbe Taktrate hat, gekennzeichnet durch:
- ein erstes Schieberegister, das synchron zur Rück- oder Vorderflanke des Taktsignals einen ungeradzahligen Teil des Eingangssignals mit einem ersten Ladesignal parallel übernimmt und als eine erste Ein-Bit-Signalfolge seriell ausgibt;
- ein zweites Schieberegister, das synchron zur Vorder- oder Rückflanke des Taktsignals einen geradzahligen Teil des Eingangssignals mit einem zweiten Ladesignal parallel übernimmt und als eine zweite serielle Ein-Bit-Signalfolge ausgibt, und
- eine Verschmelzungseinheit, die die erste serielle Ein-Bit-Signalfolge von dem ersten Schieberegister, die zweite serielle Ein-Bit-Signalfolge von dem zweiten Schieberegister und das Taktsignal empfängt und die erste serielle Ein-Bit-Signalfolge synchron mit der Rück- oder Vorderflanke des Taktsignals und die zweite serielle Ein-Bit-Signalfolge synchron mit der Vorder- oder Rückflanke des Taktsignals zu dem Ausgangssignalstrom verschmilzt und diesen ausgibt.

Gemäß einem ersten bevorzugten Ausführungsbeispiel ist n = 8, das erste und zweite Schieberegister übernehmen jeweils die ungeradzahlige und geradzahlige Vier-Bithälfte des Acht-Bit-Eingangssignals mit einem Achtel der Systemtaktrate und geben die erste und zweite serielle Ein-Bit-Signalfolge mit der halben Systemtaktrate aus.

Um eine sichere und stabile Datenübernahme in das erste und zweite Schieberegister zu erzielen, sind die Phasen des ungeradzahligen und des geradzahligen Anteils des Eingangssignals, des Taktsignals und des ersten und zweiten Ladesignals jeweils miteinander synchronisiert.

Vorteilhaft ist es, dass bei einem Ausführungsbeispiel die Phasenlage des ersten und zweiten Ladesignals oder die eines aus dem ersten bzw. zweiten Ladesignal jeweils in dem ersten und zweiten Schieberegister erzeugten internen Ladesignals relativ zur Vorder- und/oder Rückflanke des Taktsignals einstellbar ist.

Wie schon erwähnt, kann das Taktsignal als differentielles Taktsignal vorliegen. Das Taktsignal kann zusätzlich auch mit dem vollen CMOS-Pegel anliegen.

Bevorzugt wird der erfindungsgemäße Parallel-Serienwandler zur Parallel-Serienwandlung eines Datensignals in einem Sendeschaltungsabschnitt der Schnittstellenschaltung eines DDR-DRAM-Halbleiterspeichers der künftigen DDR-DRAM-Speichergenerationen eingesetzt.

Obige und weitere vorteilhafte Merkmale eines erfindungsgemäßen synchronen Parallel-Serienwandlers werden in der nachstehenden Beschreibung anhand eines bevorzugten Ausführungsbeispiels bezogen auf die Zeichnung näher beschrieben. Die Zeichnungsfiguren zeigen im Einzelnen:
- Fig. 1: schematisch einen prinzipiellen Aufbau des bevorzugten Ausführungsbeispiels des erfindungsgemäßen synchronen Parallel-Serienwandlers,
- Fig. 2 - 4: graphisch Impulszeitdiagramme zur Erläuterung der Funktion des in Fig. 1 dargestellten synchronen Parallel-Serienwandlers.

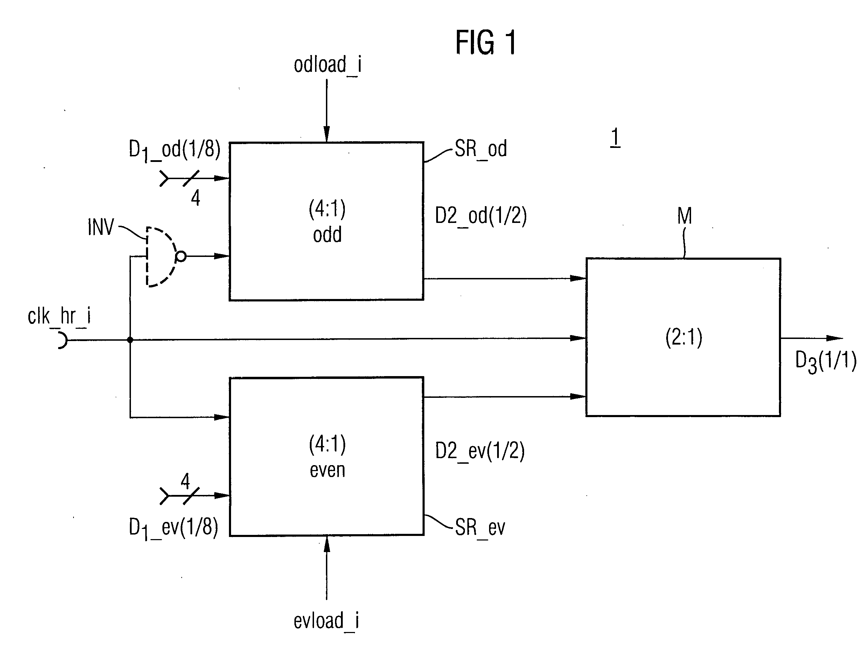

Das in Fig. 1 schematisch in Form eines Funktionsblockschaltbildes dargestellte bevorzugte Ausführungsbeispiel des erfindungsgemäßen synchronen Parallel-Serienwandlers 1 weist ein erstes (4:1) Schieberegister SR_od und ein zweites (4:1) Schieberegister SR_ev sowie eine (2:1) Verschmelzungseinheit M auf. Das erste und zweite Schieberegister SR_od und SR_ev sowie die Verschmelzungseinheit M erhalten einen von einem (nicht gezeigten) Systemtakt sys_clk abgeleiteten Halbratentakt clk_hr_i. Es ist zu bemerken, dass der Systemtakt sys_clk dem Parallel-Serienwandler nicht zugeführt werden braucht, sondern im Rahmen des hier beschriebenen lediglich fiktiv vorhanden ist.

Die Verschmelzungseinheit M ist in Verarbeitungsrichtung dem ersten und zweiten Schieberegister SR_od und SR_ev nachgeschaltet. Ein zuvor acht Bit umfassendes paralleles Eingangssignal kommt aufgeteilt in ein die ungeradzahligen vier Bit umfassendes Eingangssignal D1_od und ein die geradzahligen vier Bit umfassendes Eingangssignal D1_ev jeweils am ersten Schieberegister SR_od und am zweiten Schieberegister SR_ev an. In dem ersten Schieberegister SR_od wird mit einem Ladesignal odload_i der ungeradzahlige parallele Vier-Bitanteil D1_od des Eingangssignals synchron zur Rück-(oder Vorder-)-Flanke des Halbratentaktsignals clk_hr_i in eine erste serielle Signalfolge D2_od (1/2) umgesetzt, die die ungeradzahligen Bits des Eingangssignals umfasst. Außerdem übernimmt das zweite Schieberegister SR_ev den geradzahligen Anteil D1_ev des parallelen Eingangssignals mit dem zweiten Ladesignal evload_i synchron mit der Vorder-(oder Rück-)Flanke des Halbratentaktsignals clk_hr_i und wandelt es in eine zweite serielle Signalfolge D2_ev (1/2) um. Diese beiden aus den beiden Schieberegistern SR_od und SR_ev ausgegebenen seriellen Signalfolgen D2_od (1/2) und D2_ev empfängt die Verschmelzungseinheit M und wandelt sie synchron jeweils mit der Takt-Rück- (und -Vorder)flanke in einen seriellen Ausgangssignalstrom D3(1/1) um, der dieselbe Signalrate hat wie der Systemtakt sys_clk.

Zu bemerken ist noch, dass Fig. 1 ein Invertierglied INV gestrichelt darstellt, das optional eingesetzt werden kann und durch das erreicht wird, dass der Schaltungsaufbau des ersten und zweiten Schieberegisters SR_od und SR_ev jeweils gleich ist. Ferner ist bemerkenswert, dass das Halbratentaktsignal clk_hr_i, obwohl dies in Fig. 1 nicht dargestellt ist, als differentielles Taktsignal anliegen und auch mit vollem MOS-Pegel zugeführt werden kann. Wenn das Taktsignal clk_hr_i differentiell zugeführt wird, kann das Invertierglied INV weggelassen werden, weil statt des Invertierglieds INV positive und negative Phase vertauscht werden können.

Auf diesem Gebiet erfahrene Fachleute würden ohne weiteres feststellen, dass die beschriebenen und in Fig. 1 dargestellten Anzahlen der parallelen Eingangssignalbits nur beispielhaft sind.

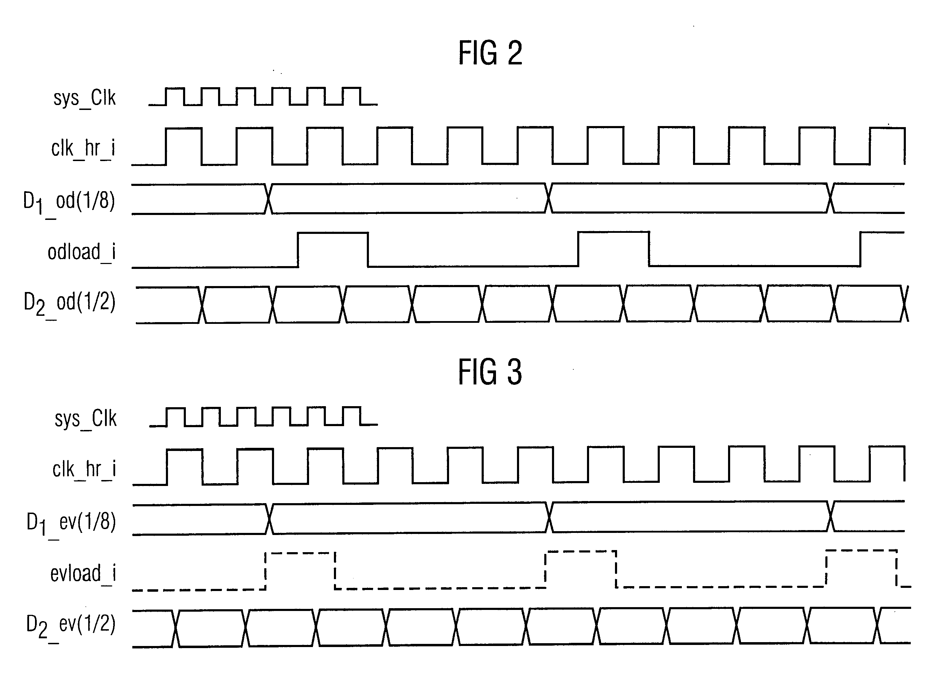

Um eine sichere Übernahme des parallelen Eingangssignals in das erste und zweite Schieberegister SR_od und SR_ev zu gewährleisten, ist es wichtig, dass die Phasen jeweils des ungeradzahligen D1_od und des geradzahligen Teils D1_ev des Eingangssignals, des Halbratentaktsignals clk_hr_i und des ersten und zweiten Ladesignals odload_i, evload_i jeweils synchron zueinander sind. Um die jeweils am ersten und zweiten Schieberegister SR_od und SR_ev ankommenden ungeradzahligen und geradzahligen Bits D1_od und D1_ev mit geringer Latenzzeit und sicher in die beiden Schieberegister zu übernehmen, ist eine feste Phasendifferenz zwischen dem ersten Ladesignal odload_i und dem zweiten Ladesignal evload_i von einem halben Taktzyklus des Halbratentaktzyklus clk_hr_i eingestellt. Die zeitlichen Verhältnisse und damit auch die Funktionen des in Fig. 1 dargestellten synchronen Parallel-Serienwandlers 1 sind in den Impulszeitdiagrammen der Fig. 2 bis 4 graphisch verdeutlicht. Dabei kann es vorteilhaft sein, wenn die gemeinsame Phasenlage des ersten und zweiten Ladesignals odload_i, evload_i oder die eines aus dem ersten und zweiten Ladesignal jeweils in dem ersten und zweiten Schieberegister erzeugten internen Ladesignals relativ zur Vorder- und/oder Rückflanke des Halbratentaktsignals clk_hr_i einstellbar ist.

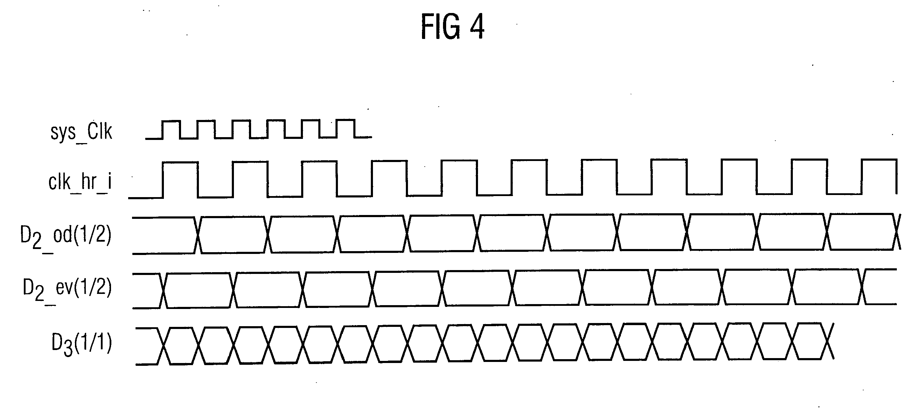

Die Signalzeitdiagramme der Fig. 2 bis 4 zeigen, dass das erste und zweite Ladesignal odload_i und evload_i zueinander die feste Phasendifferenz von einer halben Taktperiode des Halbratentaktsignals clk_hr_i haben, was eine zeitlich um eine halbe Taktperiode (halber Taktzyklus) des Halbratentaktsignals clk_hr_i versetzte Abtastung bzw. Übernahme des ungeradzahligen Anteils D1 od (1/8) in das erste Schieberegister SR_od und des geradzahligen Anteils D1_ev (1/8) in das zweite Schieberegister SR_ev und ebenfalls die zeitlich um eine halbe Taktperiode des Halbratentaktsignals clk_hr_i versetzte Ausgabe der ersten seriellen Signalfolge D2_od (1/2) aus dem ersten Schieberegister SR_od und der zweiten seriellen Signalfolge D2_ev aus dem zweiten Schieberegister SR_od ermöglicht (vgl. Fig. 4). Durch deren Abtastung jeweils mit der Vorder- und der Rückflanke des Halbratentaktsignals clk_hr_i in der Verschmelzungseinheit M kann letztere den seriellen Ausgangssignalstrom D3(1/1), der die geradzahligen und ungeradzahligen Datenbits zeitrichtig miteinander verschmolzen enthält, synchron mit dem Systemtaktsignal sys_clk und mit dessen Periodizität ausgeben.

Durch die erwähnte Einstellbarkeit der gemeinsamen Phasenlage der Vorder- und/oder Rückflanke des Ladesignals odload_i und evload_i kann die Abtastung der parallelen Bits des Eingangssignals bzw. ihre Übernahme in das erste und zweite Schieberegister SR_od und SR_ev bezogen auf den Zeitpunkt der Änderung des Eingangssignals früher oder später gelegt werden. Dies ist vorteilhaft, da der Kompromiss zwischen Latenzzeit und stabiler Abtastung des Eingangssignals wählbar (einstellbar) ist.

Im bevorzugten Ausführungsbeispiel sind die parallel-seriell gewandelten Signale Datensignale, die in einer Sendeschnittstellenschaltung eines DDR4-DRAM-Speicherchips verarbeitet werden.

### Bezugszeichenliste

- 1: synchroner Parallel-Serienwandler
- D1_od, D1_ev: ungerader und gerader paralleler Vier-Bitanteil
- clk_hr_i: Halbratentaktsignal
- sys_clk: Systemtakt
- D2_od(1/2), D2_ev(1/2): serialisierter ungeradzahliger und geradzahliger Signalanteil
- odload_i, evload_i: erstes und zweites Ladesignal
- SR_od, SR_ev: erstes und zweites Schieberegister
- M: Verschmelzungseinheit
- D3(1/1): Ausgangssignalstrom
- INV: Invertierglied

## Patentansprüche

1. Synchroner Parallel-Serienwandler zur Wandlung eines parallelen n Bit Eingangssignals in einen seriellen Ein-Bit-Ausgangssignalstrom (D3(1/1)) synchron zu einem Taktsignal (clk_hr_i), das, bezogen auf eine Taktrate eines Systemtakts (sys_clk) die halbe Taktrate hat,
**dadurch gekennzeichnet,**
**dass** der Parallel-Serienwandler (1) aufweist:
- ein erstes Schieberegister (SR_od), das synchron zur Rück- oder Vorderflanke des Taktsignals (clk_hr_i) einen ungeradzahligen Teil (D1_od(1/8)) des Eingangssignals mit einem ersten Ladesignal (odload_i) parallel übernimmt und seriell als eine erste Ein-Bit-Signalfolge (D2_od(1/2)) ausgibt;
- ein zweites Schieberegister (SR_ev), das synchron zur Vorder- oder Rückflanke des Taktsignals (clk_hr_i) einen geradzahligen Teil (D1_ev(1/8)) des Eingangssignals mit einem zweiten Ladesignal (evload_i) parallel übernimmt und seriell als eine zweite Ein-Bit-Signalfolge (D2_ev(1/2)) ausgibt, und
- eine Verschmelzungseinheit (M), die die erste Ein-Bit-Signalfolge (D2_od(1/2)) von dem ersten Schieberegister (SR_od), die zweite Ein-Bit-Signalfolge (D2_ev(1/2)) von dem zweiten Schieberegister (SR_ev) und das Taktsignal (clk_hr_i) empfängt und die erste serielle Ein-Bit-Signalfolge (D2_od(1/2)) synchron mit der Rück- oder Vorderflanke des Taktsignals (clk_hr_i) und die zweite serielle Ein-Bit-Signalfolge (D2_ev(1/2)) synchron mit der Vorder- oder Rückflanke des Taktsignals (clk_hr_i) zu dem Ausgangssignalstrom (D3(1/1)) verschmilzt und diesen ausgibt.

2. Synchroner Parallel-Serienwandler nach Anspruch 1,
**dadurch gekennzeichnet,**
**dass** n = 8 ist,
das erste und zweite Schieberegister (SR_od, SR_ev) jeweils die ungeradzahlige und geradzahlige Vier-Bithälfte des Acht-Bit-Eingangssignals mit einem Achtel der Taktrate des Systemtakts (sys_clk) übernehmen und die erste und zweite serielle Ein-Bitsignalfolge mit der halben Taktrate des Systemtakts (sys_clk) ausgeben.

3. Synchroner Parallel-Serienwandler nach Anspruch 1 oder 2,
**dadurch gekennzeichnet,**
**dass** die Phasen des ungeradzahligen (D1_od) und des geradzahligen Teils (D1_ev) des Eingangssignals, des Taktsignals (clk_hr_i) und des ersten und zweiten Ladesignals (odload_i, evload_i) jeweils miteinander synchron sind.

4. Synchroner Parallel-Serienwandler nach einem der vorangehenden Ansprüche,
**dadurch gekennzeichnet,**
**dass** die Phasenlage des ersten (odload_i) und des zweiten Ladesignals (evload_i) oder die eines aus dem ersten und zweiten Ladesignal (odload_i, evload_i) jeweils in dem ersten und zweiten Schieberegister (SR_od, SR_ev) erzeugten internen Ladesignals relativ zur Vorder- und/oder Rückflanke des Taktsignals (clk_hr_i) einstellbar ist.

5. Synchroner Parallel-Serienwandler nach einem der vorangehenden Ansprüche,
**dadurch gekennzeichnet,**
**dass** das erste und zweite Ladesignal (odload_i, evload_i) zueinander eine feste Phasendifferenz der halben Taktperiode des Taktsignals (clk_hr_i) aufweisen.

6. Synchroner Parallel-Serienwandler nach einem der vorangehenden Ansprüche,
**dadurch gekennzeichnet,**
**dass** das zugeführte Taktsignal (clk_hr_i) ein differentielles Taktsignal ist.

7. Synchroner Parallel-Serienwandler nach einem oder mehreren der vorangehenden Ansprüche,
**dadurch gekennzeichnet,**
**dass** das Taktsignal MOS-Pegel hat.

8. Verwendung des Parallel-Serienwandlers nach einem oder mehreren der vorangehenden Ansprüche zur Parallel-Serienwandlung eines Datensignals in einer Sendeschnittstellenschaltung eines DRAM-Halbleiterspeicherbausteins.

9. Verwendung nach Anspruch 8,
**dadurch gekennzeichnet,**
**dass** der DRAM-Halbleiterspeicherbaustein ein DDR4-DRAM-Speicherchip ist.
